# EUROPEAN PATENT APPLICATION

(11) **EP 4 387 402 A1**
(43) Date of publication of application: **19.06.2024**
(21) Application number: 22856232.8
(22) Date of filing: 10.08.2022
(51) Int. Cl.: H05K 1/18, H05K 1/11, H01Q 1/38, H05K 3/46

(54) **CIRCUIT BOARD**

(30) Priority: 10.08.2021 KR 20210105658
(71) Applicant: LG INNOTEK CO., LTD., Seoul 07796 (KR)
(72) Inventor: SHIN, Jong Bae, Seoul 07796 (KR); KIM, Moo Seong, Seoul 07796 (KR); LEE, Soo Min, Seoul 07796 (KR); JEONG, Jae Hun, Seoul 07796 (KR)
(74) Representative: M. Zardi & Co S.A.
(86) International application number: PCT/KR2022/011956
(87) International publication number: WO 2023/018235

(57) **Abstract**

A circuit board according to an embodiment includes a first substrate layer; and a second substrate layer disposed on the first substrate layer and including a cavity, wherein the cavity of the second substrate layer includes a first part disposed adjacent to an upper surface of the second substrate layer and having a first inclination such that a width gradually decreases toward a lower surface of the second substrate layer; and a second part disposed below the first part adjacent to the lower surface of the second substrate layer and having a second inclination such that a width gradually decreases toward the lower surface of the second substrate layer, and the first inclination of the first part relative to a bottom surface of the cavity is greater than the second inclination of the second part relative to the bottom surface of the cavity, and a vertical length of the first part is different from a vertical length of the second part.

## Description

### [Technical Field]

An embodiment relates to a circuit board, particularly a circuit board including an antenna pattern and antenna package substrate.

### [Background Art]

Recently, in order to meet a demand for wireless data traffic, efforts have been made to develop an improved 5G (5th generation) communication system or a pre-5G communication system.

The 5G communication system uses ultra-high frequency (mm-Wave) bands (sub 6GHz, 28GHz, 38GHz, or higher frequencies) to achieve high data transfer rates.

In order to reduce a path loss of radio waves and increase a transmission distance of radio waves in the ultra-high frequency band, in the 5G communication system, integration technologies such as beamforming, massive multi-input multi-output (massive MIMO), and array antennas have been developed.

Considering that it may be composed of hundreds of active antennas of wavelengths in the frequency bands, an antenna system becomes large relatively.

This means that several substrates constituting the active antenna system, that is, an antenna substrate, an antenna power feeding substrate, a transceiver substrate, and a baseband substrate, should be integrated into one compact unit.

Accordingly, the circuit board applied to the 5G communication system of a prior art had a structure in which several boards as described above were integrated, and thus had a relatively thick thickness. Accordingly, in the prior art, the overall thickness of the circuit board is reduced by thinning the thickness of the insulating layer constituting the circuit board.

However, there are limitations in manufacturing a circuit board by thinning the thickness of the insulating layer, and furthermore, if the thickness of the insulating layer becomes thin, there is a problem in that the circuit pattern is not stably protected.

### [Disclosure]

### [Technical Problem]

The embodiment provides a circuit board with a new structure and an antenna package substrate including the same.

Additionally, the embodiment provides a circuit board capable of slimming the circuit board and an antenna package substrate including the same.

Additionally, the embodiment provides a circuit board capable of minimizing a distance between a signal line on which a driving device is disposed and a signal line on which an antenna pattern is disposed, and an antenna package substrate including the same.

Additionally, the embodiment provides a circuit board including a cavity in which a driving device is mounted and an antenna package substrate including the same.

Additionally, the embodiment provides a circuit board including a cavity having at least two different inclinations and an antenna package substrate including the same.

Additionally, the embodiment provides a circuit board that can minimize damage to a pad exposed through a cavity during a laser process for forming a cavity, and a package substrate including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment includes a first substrate layer; and a second substrate layer disposed on the first substrate layer and including a cavity, wherein the cavity of the second substrate layer includes a first part disposed adjacent to an upper surface of the second substrate layer and having a first inclination such that a width gradually decreases toward a lower surface of the second substrate layer; and a second part disposed below the first part adjacent to the lower surface of the second substrate layer and having a second inclination such that a width gradually decreases toward the lower surface of the second substrate layer, wherein the first inclination of the first part relative to a bottom surface of the cavity is greater than the second inclination of the second part relative to the bottom surface of the cavity, and wherein a vertical length of the first part is different from a vertical length of the second part.

In addition, the first inclination of the first part relative to the bottom surface of the cavity ranges between 115 degrees and 150 degrees, and the second inclination of the second part relative to the bottom surface of the cavity ranges between 91 degrees and 110 degrees.

In addition, the vertical length of the first part is shorter than the vertical length of the second part.

In addition, the vertical length of the second part satisfies a range of 1.5 to 30 times the vertical length of the first part.

In addition, the first substrate layer includes at least one first insulating layer, a first circuit pattern layer disposed on the at least one first insulating layer, and a first through electrode part passing through the at least one first insulating layer, wherein the second substrate layer includes a plurality of second insulating layers, a second circuit pattern layer disposed on the plurality of second insulating layers, and a second through electrode part passing through at least one of the plurality of second insulating layers.

In addition, the second circuit pattern layer of the second substrate layer includes a first antenna pattern layer.

In addition, the first substrate layer includes a first region overlapping with the cavity in a vertical direction, and a second region other than the first region, wherein an upper surface of the first region of the first substrate layer has a step difference from an upper surface of the second region of the first substrate layer, and the bottom surface of the cavity is positioned lower than a lower surface of the second substrate layer.

In addition, a first circuit pattern layer formed in the second region of the first substrate layer includes a second antenna pattern layer connected to the first antenna pattern layer.

In addition, the first insulating layer includes a first-first insulating layer disposed closest to the second substrate layer, and wherein an upper surface of the first-first insulating layer includes a first upper surface overlapping the cavity in a vertical direction, and a second upper surface other than the first upper surface, and wherein the first upper surface and the second upper surface have a step difference.

In addition, the first circuit pattern layer includes a first circuit pattern disposed on the upper surface of the first-first insulating layer, wherein the first circuit pattern includes a first-first pattern disposed on the first upper surface of the first-first insulating layer and overlapping the cavity in the vertical direction, and a first-second pattern disposed on the second upper surface of the first-first insulating layer.

In addition, an upper surface of the first-first pattern is positioned lower than an upper surface of the first-second pattern.

In addition, the first circuit pattern layer includes a first-third pattern disposed adjacent to the cavity on the second upper surface of the first-first insulating layer and having a side surface that overlaps the cavity in a horizontal direction.

In addition, the cavity includes a third part having a third inclination corresponding to the side surface of the first-third pattern.

Meanwhile, an antenna package substrate according to the embodiment includes a circuit board, a connection part disposed on a first-first pattern of the circuit board; a device mounted on the connection part; and a molding layer disposed in a cavity of the circuit board and covering the device, wherein the circuit board includes a first substrate layer and a second substrate layer disposed on the first substrate layer, wherein the first substrate layer includes at least one first insulating layer, and a first circuit pattern layer disposed on the at least one first insulating layer, wherein the second substrate layer includes a plurality of second insulating layers, and a second circuit pattern layer disposed on the plurality of second insulating layers and constituting an antenna pattern, wherein the second substrate layer includes a cavity passing through the plurality of second insulating layers, wherein the first insulating layer includes a first-first insulating layer disposed closest to the first substrate layer, wherein the first circuit pattern layer includes a first circuit pattern disposed on the upper surface of the first-first insulating layer, wherein the first circuit pattern includes a first-first pattern formed in a first region overlapping in a vertical direction with the cavity, and a first-second pattern formed in a second region other than the first region, and wherein an upper surface of the first-first pattern is positioned lower than an upper surface of the first-second pattern.

In addition, the cavity of the second substrate layer includes a first part disposed adjacent to an upper surface of the second substrate layer and having a first inclination such that a width gradually decreases toward a lower surface of the second substrate layer; and a second part disposed below the first part adjacent to the lower surface of the second substrate layer and having a second inclination such that a width gradually decreases toward the lower surface of the second substrate layer, wherein the first inclination of the first part relative to a bottom surface of the cavity is greater than the second inclination of the second part relative to the bottom surface of the cavity, and wherein a vertical length of the first part is different from a vertical length of the second part.

In addition, the first inclination of the first part relative to the bottom surface of the cavity ranges between 115 degrees and 150 degrees, and the second inclination of the second part relative to the bottom surface of the cavity ranges between 91 degrees and 110 degrees.

In addition, the vertical length of the first part is shorter than the vertical length of the second part.

### [Advantageous Effects]

According to an embodiment, the circuit board includes a first substrate layer and a second substrate layer. The second substrate layer includes a cavity. Additionally, the first substrate layer includes a first region vertically overlapping the cavity and a second region excluding the first region. Additionally, the second substrate layer includes a third region corresponding to the cavity and a fourth region excluding the third region. At this time, the third region of the second substrate layer in the embodiment is a region where the driving device is mounted, and the fourth region is a region where the antenna pattern layer is disposed. In the above embodiment, the antenna pattern layer is disposed in the fourth region of the second substrate layer horizontally adjacent to the driving device while mounting the driving device using the cavity of the second substrate layer. Accordingly, the embodiment can minimize a signal transmission distance between the antenna pattern layer and the driving device, and thereby minimize signal transmission loss. For example, the embodiment can reduce the signal transmission distance compared to a comparative example in which a substrate on which the driving device is disposed and a substrate on which the antenna pattern layer is disposed are connected using a separate connection means, and accordingly, signal transmission loss caused by a separate connection means can be reduced. In addition, the embodiment provides a structure in which the antenna pattern layer and the driving device are disposed in the horizontal direction, and accordingly, the second region of the first substrate layer that vertically overlaps the fourth region of the second substrate layer can be used as a second antenna pattern layer, and furthermore, it is possible to enable antenna pattern radiation and signal reception in different directions from one circuit pattern.

Additionally, the embodiment can reduce an overall thickness of the circuit board to correspond to a depth of the cavity by mounting the driving device in the cavity of the second substrate layer.

Additionally, the cavity of the embodiment includes a first part with a first inclination and a second part with a second inclination different from the first inclination. At this time, with respect to the bottom surface of the cavity, the second inclination has a smaller inclination angle than the first inclination. Additionally, a vertical length of the second part having the second inclination in the embodiment is longer than a vertical length of the first part having the first inclination. Accordingly, the embodiment can reduce a space occupied by the cavity compared to the comparative example, and thus improve circuit integration. For example, the embodiment can reduce the space occupied by the cavity and increase the length of the antenna pattern layer in a substrate having a same size as the comparative example, thereby improving communication performance.

In addition, the first substrate layer of the embodiment includes a first-first insulating layer disposed closest to the first substrate layer, and a first circuit pattern disposed on the upper surface of the first-first insulating layer. At this time, the first circuit pattern includes a first-first pattern formed in a first region vertically overlapping the cavity, and a first-second pattern formed in the second region excluding the first region. An upper surface of the first-first pattern is positioned lower than an upper surface of the first-second pattern. Accordingly, the embodiment can prevent the surface of the first-first pattern from being damaged in the laser process for forming the cavity, and thus improve the electrical and physical reliability of the circuit board.

### [Description of Drawings]

FIG. 1a is a view showing a circuit board of a comparative example.
FIG. 1b is a view showing an antenna package substrate of a comparative example.
FIG. 2 is a view showing a circuit board according to an embodiment.
FIG. 3a is an enlarged view of a cavity region of FIG. 2 according to a first embodiment.
FIG. 3b is an enlarged view of a cavity region of FIG. 2 according to a second embodiment.
FIG. 3c is an enlarged view of a cavity region according to a third embodiment.
FIGS. 4a and 4b are plan views of a second substrate layer viewed from a top.
FIG. 5 is a view showing an antenna package substrate according to an embodiment.
FIGS. 6a to 6o are diagrams showing a method for manufacturing a circuit board according to an embodiment shown in FIG. 2 in order of process.

### [Modes of the Invention]

Hereinafter, embodiments of the present invention will be described in detail with reference to the accompanying drawings.

However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms may be construed the same meaning as commonly understood by one of ordinary skill in the art to which this invention belongs, and the terms such as those defined in commonly used dictionaries may be interpreted as having a meaning that is consistent with their meaning in the context of the relevant art.

Further, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

Before describing embodiments of the present invention, a circuit board according to a comparative example will be described. Preferably, an antenna circuit board for an antenna package will be described below.

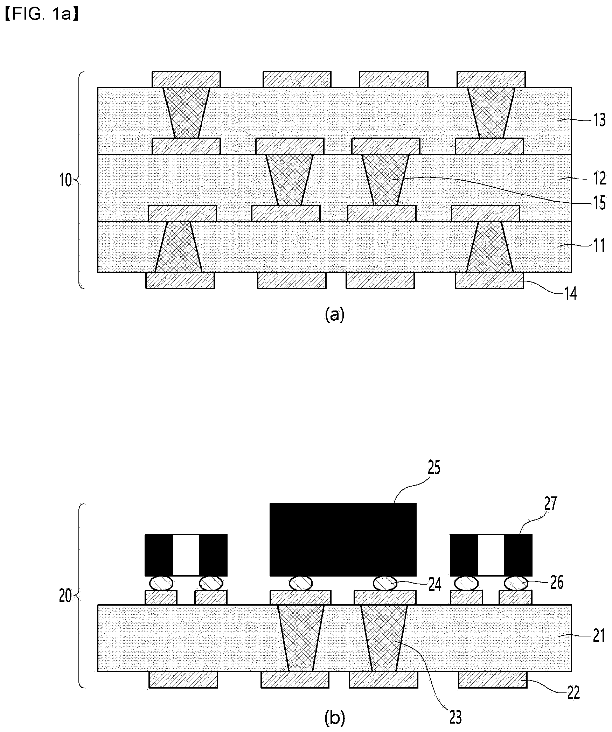

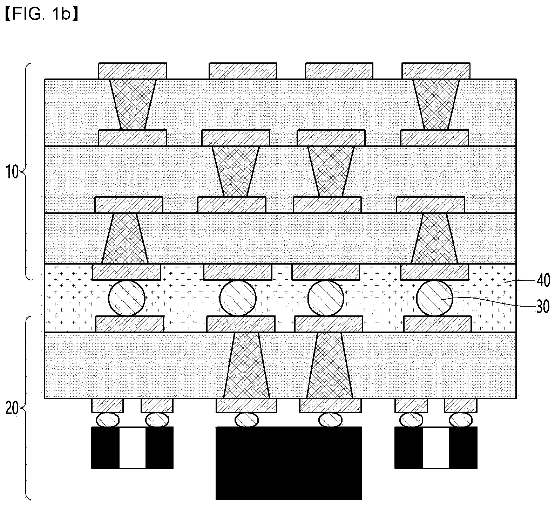

FIG. 1a is a view showing a circuit board of a comparative example, and FIG. 1b is a view showing an antenna package substrate of a comparative example.

FIG. 1a (a) is a view showing a first substrate of a comparative example, and FIG. 1a (b) is a view showing a second substrate of a comparative example.

Referring to (a) and (b) of FIG. 1a, the comparative example includes a first substrate 10 and a second substrate 20.

The first substrate 10 may also be referred to as an antenna substrate on which an antenna pattern is arranged. For example, the first substrate 10 may form an antenna unit in an antenna package substrate.

The first substrate 10 includes a plurality of insulating layers.

For example, the first substrate 10 may have a plurality of insulating layer structures to improve radiation characteristics of an antenna pattern. For example, the first substrate 10 includes a first-first insulating layer 11, a first-second insulating layer 12, and a first-third insulating layer 13.

The first substrate 10 includes a first circuit pattern 14 disposed on a plurality of insulating layers. For example, the first circuit pattern 140 may represent an antenna pattern that transmits a signal from the first substrate 10 to an outside or receives a signal transmitted from the outside.

The first circuit pattern 14 may be disposed on each surface of a plurality of insulating layers.

For example, the first circuit pattern 14 may be disposed on a lower surface of the first-first insulating layer 11. For example, the first circuit pattern 14 may be disposed between an upper surface of the first-first insulating layer 11 and a lower surface of the first-second insulating layer 12. For example, the first circuit pattern 14 may be disposed between an upper surface of the first-second insulating layer 12 and a lower surface of the first-third insulating layer 13. For example, the first circuit pattern 14 may be disposed on an upper surface of the first-third insulating layer 13.

Additionally, the first substrate 10 includes a through electrode 15. The through electrode 15 is formed to pass through a plurality of insulating layers constituting the first substrate 10. For example, the through electrode 15 is formed to pass through the first-first insulating layer 11, the first-second insulating layer 12, and the first-third insulating layer 13. Through this, the through electrode 15 can electrically connect the first circuit patterns disposed on different insulating layers.

Additionally, the second substrate 20 is manufactured by a separate process from the first substrate 10.

For example, in the comparative example, the first substrate 10 and the second substrate 20 are manufactured by separate processes, and a process of coupling them is performed through this.

The second substrate 20 includes a second insulating layer 21. At this time, the second insulating layer 21 may have a single-layer structure or, alternatively, may have a plurality of layer structure.

The second substrate 20 includes a second circuit pattern 22 disposed on a surface of the second insulating layer 21. For example, the second substrate 20 includes a second circuit pattern disposed on an upper surface of the second insulating layer 21. At this time, the second circuit pattern disposed on the upper surface of the second insulating layer 21 can be used as a mounting pad for mounting a device. Additionally, the second substrate 20 includes a second circuit pattern disposed on a lower surface of the second insulating layer 21. At this time, the second circuit pattern disposed on the lower surface of the second insulating layer 21 may function as a connection between the device and the first substrate 10.

For example, a first connection part 24 and a second connection part 26 are disposed on the second circuit pattern disposed on the upper surface of the second insulating layer 21. The first connection part 24 and the second connection part 26 may refer to a solder ball.

Additionally, a driving device 25 is disposed on the first connection part 24. The driving device 25 may refer to an element for driving an antenna in an antenna device. For example, the driving device 25 can transmit a transmission signal to the first substrate 10, thereby allowing a wireless signal corresponding to the transmission signal to be transmitted to the outside through an antenna pattern. In addition, the driving device 25 can receive a received signal through the first substrate 10 and analyze the received signal to confirm received information.

Additionally, a passive device 25 is disposed on the second connection part 37. The passive device 25 may be a device that supports an operation of the driving device 25. For example, the passive device 25 may include a resistor, a capacitor, and an inductor.

Additionally, the second substrate 20 includes a second through-electrode 23 disposed in the second insulating layer 23. The second through electrode 23 electrically connects second circuit patterns disposed on different layers of the second insulating layer 23 to each other. For example, the second through electrode 23 may electrically connect the driving device 25 and the antenna pattern of the first substrate 10 to each other.

Meanwhile, referring to FIG. 1b, the antenna package substrate in the comparative example has a structure in which the first substrate 10 and the second substrate 20 manufactured through separate processes as described above are coupled by solder balls 30.

At this time, the solder ball 30 has a structure covered by a separate molding layer 40.

However, in the antenna package substrate of the comparative example as shown in FIG. 1B, the first substrate 10 constituting the antenna pattern and the second substrate 20 including the driving device or passive device are coupled in a vertically aligned state. In addition, in the antenna package substrate of the comparative example, a separate connection means (e.g., solder ball, 30) is disposed between the first substrate 10 and the second substrate 20, and the first substrate 10 and the second substrate 20 has a structure that is electrically connected to each other through the connection means.

Accordingly, in the comparative example, the first substrate 10 and the second substrate 20 are connected to each other through the solder ball 30, and accordingly, there is a problem that a thickness of the antenna package substrate increases by a height of the solder ball 30.

Furthermore, in the comparative example, the first substrate 10 and the second substrate 20 have a vertical stacked structure and are coupled to each other through the solder ball 30 as described above, and accordingly, the transmission length of the signal increases, and there is a problem that signal loss increases as a transmission length (e.g., signal transmission distance) increases.

Additionally, in the comparative example, the first substrate 10 and the second substrate 20 were connected through a connector structure using a separate flexible circuit board (not shown) instead of the solder ball 30. However, if the first substrate 10 and the second substrate 20 are electrically connected to each other using the flexible circuit board, although the first and second substrates have a horizontal arrangement structure, there is a problem that signal loss increases because the signal transmission distance increases by the length of the flexible printed circuit board.

Meanwhile, the antenna device applied to the 5G communication system transmits and receives a large amount of data than a general communication system. In order to transmit and receive the large amount of data as described above, battery capacity must increase as battery consumption increases. In order to increase a battery capacity, the size of the battery must be increased, and a battery placement space must be increased accordingly.

Accordingly, in order to maintain a size of the antenna device (e.g., mobile terminal) while increasing the battery size, the general 5G communication system is reducing a thickness of the antenna package substrate as described above.

At this time, in order to reduce the thickness of the antenna package substrate, a thickness of the insulating layer constituting the antenna package substrate or a thickness of the antenna pattern must be reduced, but there is a limit to reducing this. In addition, if the thickness of the antenna pattern is randomly reduced, there is a problem that communication performance decreases (for example, a transmission strength of a transmission signal or a reception strength of a reception signal decreases). In addition, if reducing a thickness of the insulating layer, there is a problem that communication errors occur due to the antenna pattern not being stably protected.

Accordingly, the embodiment allows an antenna part on which the antenna pattern is disposed and a driving part on which the driving device is arranged to be composed of a single circuit board, so that it is possible to remove separate connection means such as the solder ball or flexible circuit board. Furthermore, the embodiment forms a cavity in the circuit board in which the driving device is disposed and allows the driving element to be disposed in the formed cavity, so that it allows the drive device to be placed and thus reduces the overall thickness of the circuit board. Furthermore, the embodiment allows the antenna part and the driving part to be arranged horizontally rather than vertically on one substrate, so that it is possible to maximize communication performance in the antenna part (for example, to enable transmission of a transmission signal or reception of a reception signal from both sides of the circuit board, respectively). This will be explained in more detail below.

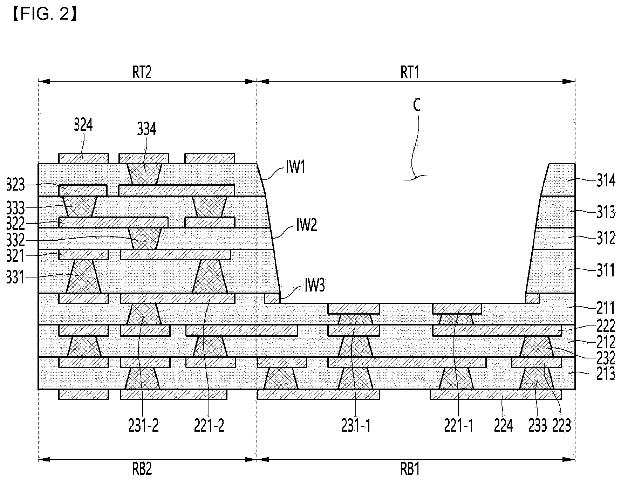

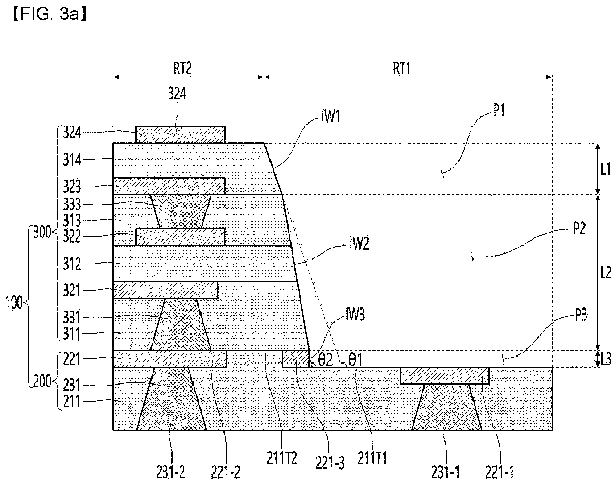

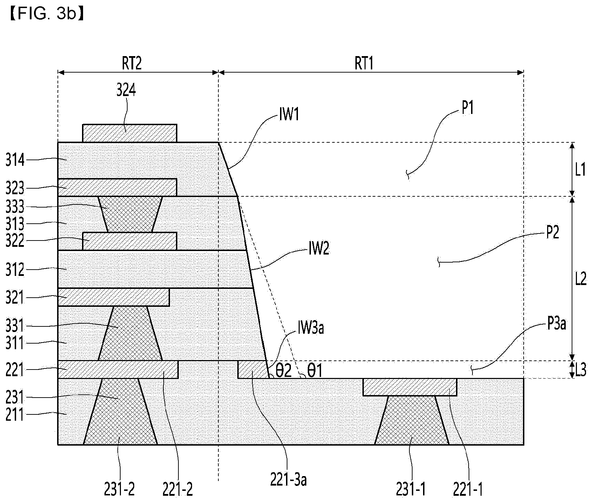

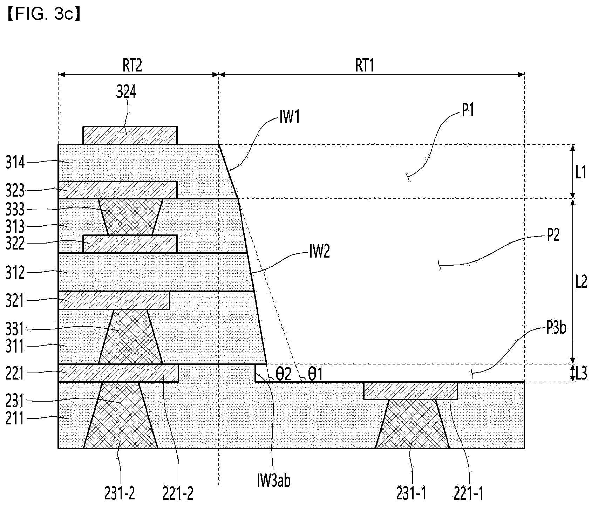

FIG. 2 is a view showing a circuit board according to an embodiment, FIG. 3a is an enlarged view of a cavity region of FIG. 2 according to a first embodiment, FIG. 3b is an enlarged view of a cavity region of FIG. 2 according to a second embodiment, and FIG. 3c is an enlarged view of a cavity region according to a third embodiment.

Hereinafter, a circuit board according to an embodiment will be described in detail with reference to FIGS. 2, 3a, 3b, and 3c.

First, briefly describing a basic structure of a circuit board 300 of the embodiment, the circuit board 300 of the embodiment may be provided to drive, feed, and support an antenna part. For example, the circuit board 300 may be a printed circuit board (PCB). This circuit board 300 has a flat structure. This circuit board 300 may have a multi-layer structure in which multiple layers are stacked.

The circuit board 300 may include a ground layer (not shown) for grounding and a power feeder (not shown) for feeding power.

The circuit board 300 of the embodiment may be divided into an antenna part on which a conductive antenna pattern layer is formed and a driving part including a driving device for driving the antenna part according to a conductive antenna pattern layer of an antenna region. The conductive antenna pattern layer may refer to a circuit pattern described below.

The conductive antenna pattern layer may be provided for signal transmission and reception in the circuit board of the embodiment. For example, the conductive antenna pattern layer can transmit and receive signals in a predetermined resonant frequency band. For example, the conductive antenna pattern layer may operate in a resonant frequency band to transmit and receive electromagnetic waves. The conductive antenna pattern layer may operate as power is supplied from a power feeder (not shown) of the circuit board 300, and the power supply operation of the power feeder may be performed by control of the driving part.

The conductive antenna pattern layer may resonate in a plurality of resonance frequency bands. For example, the conductive antenna pattern layer may be a dual resonance antenna that resonates in different resonance frequency bands. For example, the conductive antenna pattern layer may be a dual resonance antenna that resonates in a first frequency band of 24.03 GHz to 25.81 GHz and a second frequency band of 27.07 GHz to 28.80 GHz, but is not limited thereto. The resonance frequency band of the conductive antenna pattern layer may vary depending on the communication standard of the antenna device to which the circuit board is applied.

The circuit board 300 of the embodiment may include a first substrate layer 200 and a second substrate layer 300.

At this time, the first substrate layer 200 and the second substrate layer 300 do not mean a plurality of substrates that are manufactured separately from each other and then later bonded through a bonding layer. For example, the first substrate layer 200 and the second substrate layer 300 may be for distinguishing between within one circuit board a region where the cavity C is formed in a thickness direction of the circuit board and a region excluding the region where the cavity C is formed.

The first substrate layer 200 may have a single layer structure or, alternatively, may have a multiple layer structure. For example, the first substrate layer 200 may include only one insulating layer, or alternatively, may include two or more insulating layers. However, the first substrate layer 200 allows a driving device (described later) to be mounted, so that the first substrate layer 200 can be connected to a main board of the antenna device (e.g., mobile terminal) to which the circuit board is applied while connecting the mounted driving device and the conductive antenna pattern layer (described later). At this time, if the first substrate layer 200 has a single-layer structure, a horizontal width of the first substrate layer 200 may increase in order to be connected to the antenna pattern and the main board. Accordingly, the first substrate layer 200 has a layer structure of at least two layers and connects the conductive antenna pattern layer to the main board, so that the embodiment reduces the width of the circuit board in the horizontal direction and reduces the signal transmission distance. Hereinafter, the first substrate layer 200 will be described as having a two-layer or more layer structure. However, the embodiment is not limited to this, and the first substrate layer 200 may have a single-layer structure.

The second substrate layer 300 may be disposed on the first substrate layer 200. The second substrate layer 300 may have a layer structure of at least two layers.

The second substrate layer 300 may provide a cavity C in which the driving device will be disposed while the conductive antenna pattern layer is disposed. At this time, if the second substrate layer 300 has a single-layer structure, the cavity C in which the driving device will be placed may not have sufficient space (e.g., depth). Furthermore, the second substrate layer 300 is a region where a conductive antenna pattern layer is disposed. At this time, if the second substrate layer 300 has a single-layer structure, communication performance achieved through the conductive antenna pattern layer may be reduced. For example, the communication performance may increase or decrease in proportion to a length of the conductive antenna pattern layer. At this time, if the second substrate layer 300 has a single-layer structure, a width of a remaining region of the second substrate layer 300, excluding the region where the cavity C is formed, may be significantly increased to ensure that the communication performance is above a certain level. Accordingly, in the embodiment, the second substrate layer 300 has a layer structure of at least two layers, so that this allows the length of the conductive antenna pattern layer to be secured to satisfy the communication performance and the space in the cavity C for mounting the driving device to be secured.

Hereinafter, the first substrate layer 200 and the second substrate layer 300 according to the embodiment will be described in detail.

The first substrate layer 200 may include a first insulating layer, a circuit pattern, and a through electrode. The through electrode functions to connect circuit patterns disposed in different layers, and may also be referred to as a 'via'.

The first substrate layer 200 may include a first insulating layer. The first insulating layer may have a multiple layer structure, or alternatively, may have a single layer structure. At this time, the first insulating layer is shown in the drawing as having a three-layer structure, but the embodiment is not limited thereto. However, hereinafter, the first insulating layer will be described as having a three-layer structure for convenience of explanation. However, the first insulating layer may have a layer structure of two or fewer layers, and alternatively, may have a layer structure of four or more layers.

The first insulating layer may include a first-first insulating layer 211, a first-second insulating layer 212, and a first-third insulating layer 213. For example, the first insulating layer may include a first-first insulating layer 211, a first-second insulating layer 212, and a first-third insulating layer 213 from a top.

The first-first insulating layer 211 may refer to an uppermost insulating layer disposed closest to the second substrate layer 300 among the first insulating layers. Additionally, the first-third insulating layer 213 may refer to a lowest insulating layer furthest from the second substrate layer 300 among the first insulating layers. Additionally, the first-second insulating layer 212 may refer to an inner insulating layer disposed between the uppermost insulating layer and the lowermost insulating layer.

The insulating layer can be composed of a prepreg. The prepreg can be formed by impregnating an epoxy resin or the like into a fiber layer in the form of a fabric sheet, such as a glass fabric woven with glass fiber yarn, and then performing heat compression. However, the embodiment is not limited thereto, and the prepreg constituting the insulating layer can include a fiber layer in the form of a fabric sheet woven with carbon fiber yarn.

The insulating layer can include a resin and a reinforcing fiber disposed in the resin. The resin can be an epoxy resin, but is not limited thereto. The resin is not particularly limited to the epoxy resin, and for example, one or more epoxy groups can be included in the molecule, or alternatively, two or more epoxy groups can be included, or alternatively, four or more epoxy groups can be included. In addition, the resin can include a naphthalene group, for example, can be an aromatic amine type, but is not limited thereto. For example, the resin can be include a bisphenol A type epoxy resin, a bisphenol F type epoxy resin, a bisphenol S type epoxy resin, a phenol novolac type epoxy resin, an alkylphenol novolac type epoxy resin, a biphenyl type epoxy resin, an aralkyl type epoxy resin, dicyclopentadiene type epoxy resin, naphthalene type epoxy resin, naphthol type epoxy resin, epoxy resin of condensate of phenol and aromatic aldehyde having phenolic hydroxyl group, biphenyl aralkyl type epoxy resin, fluorene type epoxy resin resins, xanthene-type epoxy resins, triglycidyl isocyanurate, rubber-modified epoxy resins, phosphorous-based epoxy resins, and the like, and naphthalene-based epoxy resins, bisphenol A-type epoxy resins, and phenol novolac epoxy resins, cresol novolac epoxy resins, rubber-modified epoxy resins, and phosphorous-based epoxy resins. In addition, the reinforcing fiber can include glass fiber, carbon fiber, aramid fiber (e.g., aramid-based organic material), nylon, silica-based inorganic material or titania-based inorganic material. The reinforcing fibers can be arranged in the resin to cross each other in a planar direction.

Meanwhile, the glass fiber, carbon fiber, aramid fiber (e.g., aramid-based organic material), nylon, silica-based inorganic material or titania-based inorganic material can be used.

However, the embodiment is not limited to this, and the insulating layer may include other insulating materials.

Unlike this, at least one of the plurality of insulating layers constituting the first insulating layer may include a prepreg, and the other insulating layer may include an insulating material other than the prepreg.

For example, the insulating layer may be rigid or flexible. For example, the insulating layer may include glass or plastic. In detail, the insulating layer may include chemically tempered /semi-tempered glass such as soda lime glass or aluminosilicate glass, etc., a tempered or flexible plastic such as polyimide (PI), or polyethylene terephthalate (PET), propylene glycol (PPG), polycarbonate (PC), etc., or sapphire. In addition, the insulating layer may include an optical isotropic film. As an example, the insulating layer may include cyclic olefin copolymer (COC), cyclic olefin polymer (COP), optical isotropic polycarbonate (PC), optical isotropic polymethyl methacrylate (PMMA), or the like. In addition, the insulating layer may be formed of a material including an inorganic filler and an insulating resin. For example, the material constituting the insulating layer may include a resin including a reinforcing material such as an inorganic filler such as silica or alumina together with a thermosetting resin such as an epoxy resin or a thermoplastic resin such as polyimide, specifically, ABF (Ajinomoto Build-up Film), FR-4, BT (Bismaleimide Triazine), PID (Photo Imageable Dielectric Resin), BT, etc. For example, the first insulating layer may be composed of RCC (Resin coated copper).

Each insulating layer constituting the first insulating layer may have a thickness ranging from 10um to 60um. For example, the first-first insulating layer 211, the first-second insulating layer 212, and the first-third insulating layer 213 may each have a thickness ranging from 10 µm to 60 µm. For example, the first-first insulating layer 211, the first-second insulating layer 212, and the first-third insulating layer 213 may each have a thickness ranging from 12 µm to 50 µm. For example, each of the first-first insulating layer 211, first-second insulating layer 212, and first-third insulating layer 213 may have a thickness of 15 µm to 40 µm.

If the thickness of the first-first insulating layer 211, first-second insulating layer 212, and first-third insulating layer 213 is less than 10um, the circuit pattern included in the circuit board may not be reliably protected. If the thickness of each of the first-first insulating layer 211, first-second insulating layer 212, and first-third insulating layer 213 exceeds 60um, the overall thickness of the circuit board may increase. In addition, if the thickness of each of the first-first insulating layer 211, first-second insulating layer 212, and first-third insulating layer 213 exceeds 60um, the thickness of the circuit pattern or via increases correspondingly, and the loss of the signal transmitted through the circuit pattern may increase accordingly.

The first substrate layer 200 of the embodiment may include a first circuit pattern layer. For example, the first substrate layer 200 may include a first circuit pattern layer disposed on the surface of the first insulating layer.

For example, the first substrate layer 200 may include a first circuit pattern 221 disposed on an upper surface of the first-first insulating layer 211. For example, the first substrate layer 200 may include a second circuit pattern 222 disposed between a lower surface of the first-first insulating layer 211 and an upper surface of the first-second insulating layer 212. For example, the first substrate layer 200 may include a third circuit pattern 223 disposed between a lower surface of the first-second insulating layer 212 and an upper surface of the first-third insulating layer 213. For example, the first substrate layer 200 may include a fourth circuit pattern 224 disposed on a lower surface of the first-third insulating layer 213.

The first circuit pattern 221 may be embedded in the first insulating layer. For example, the first circuit pattern 221 may have a structure buried in an upper portion of the first insulating layer. For example, the first circuit pattern 221 may be disposed in an insulating layer to be disposed on an uppermost side of the first insulating layer. The first circuit pattern 221 may refer to a circuit pattern disposed on an uppermost side of the first circuit pattern layer. Additionally, the first circuit pattern 221 may be embedded in an uppermost insulating layer disposed on an uppermost side of the first insulating layer. At this time, the fact that the first circuit pattern 221 is embedded may mean that at least a portion of an upper surface of the first circuit pattern 211 does not overlap an upper surface of the first-first insulating layer 211. Additionally, this may mean that at least a portion of a side surface and a lower surface of the first circuit pattern 221 are covered by the first-first insulating layer 211.

Meanwhile, the upper surface of the first circuit pattern 221 may have a step difference (e.g., different heights) depending on a position.

For example, the first substrate layer 200 may be divided into a plurality of regions in a width or length direction.

For example, the first substrate layer 200 may include a first region RB1 vertically overlapping with the cavity C of the second substrate layer 300 and a second region RB2 other than the first region RB1. The first region RB1 may be a region that overlaps the cavity C of the second substrate layer 300. Differently, the first region RB1 may be a region that overlaps a lower surface or bottom surface of the cavity C of the second substrate layer 300. That is, the cavity C of the embodiment may have different upper and lower widths. For example, the cavity C may have a shape in which the upper width is greater than the lower width. For example, the cavity C may have an inclination where the upper width is greater than the lower width.

In addition, the first circuit pattern 221 includes a first pattern portion disposed on an upper surface of the first region RB1 of the first-first insulating layer 211, and a second pattern portion disposed on the upper surface of the second region RB2 of the first-first insulating layer 211. Also, a height of the first pattern portion may be different from a height of the second pattern portion. For example, the first pattern portion may have a step difference from the second pattern portion. For example, the upper surface of the first pattern portion may be disposed on a different plane from the upper surface of the second pattern portion. For example, the upper surface of the first pattern portion may be positioned lower than the upper surface of the second pattern portion.

As described above, in the embodiment, the first pattern portion of the first circuit pattern 221 disposed in the first region RB1 is disposed lower than the second pattern portion disposed in the second region RB2, so that it can minimize damage to the first pattern portion that occurs during the forming process of the cavity C. This will be explained in more detail below.

Meanwhile, the first circuit pattern layers as described above may be formed of at least one metal material selected from among gold (Au), silver (Ag), platinum (Pt), titanium (Ti), tin (Sn), copper (Cu), and zinc (Zn). In addition, the first circuit pattern layers may be formed of paste or solder paste including at least one metal material selected from among gold (Au), silver (Ag), platinum (Pt), titanium (Ti), tin (Sn), copper (Cu), and zinc (Zn), which are excellent in bonding force. Preferably, the first circuit pattern layers may be formed of copper (Cu) having high electrical or thermal conductivity and a relatively low cost.

The first circuit pattern layers can have a thickness T1 in a range of 5um to 20um. For example, the first circuit pattern layers can have a thickness in a range of 6um to 17um. The first circuit pattern layers can have a thickness in a range of 7um to 16um. If the thickness of the first circuit pattern layers is less than 5um, a resistance of the circuit pattern layer increases, which may reduce signal transmission efficiency. For example, if the thickness of the first circuit pattern layers is less than 5um, signal transmission loss may increase. For example, if the thickness of the exceeds 20um, a line width of the circuit pattern layers increases, and thus an overall volume of the circuit board may increase.

The first circuit pattern layer can be formed using an additive process, a subtractive process, a modified semi additive process (MSAP) and a semi additive process (SAP), which is a typical circuit board manufacturing process, and a detailed description will be omitted here.

Meanwhile, the first substrate layer 200 includes a through electrode. The first through electrode may be formed to pass through the first insulating layer constituting the first substrate layer 200. For example, the first substrate layer 200 may include a first through electrode 231 that pass through the first-first insulating layer 211. For example, the first substrate layer 200 may include a first through electrode 231 that passes through the uppermost insulating layer disposed on the uppermost side of the first insulating layer.

The first through electrode 231 passes through the first-first insulating layer 211, and thus can electrically connect the first circuit pattern 221 and the second circuit pattern 222.

Additionally, the first substrate layer 200 may include a second through electrode 232 that passes through the first-second insulating layer 212.

The second through electrode 232 passes through the first-second insulating layer 212, and thus can electrically connect the second circuit pattern 222 and the third circuit pattern 223.

Additionally, the first substrate layer 200 may include a third through electrode 233 that passes through the first-third insulating layer 213.

The third through electrode 233 passes through the first-third insulating layer 213, and thus can electrically connect the third circuit pattern 223 and the fourth circuit pattern 224.

The through electrode as described above may be formed by filling the inside of a through hole passing through the first insulating layer with a conductive material. The through hole passing through the first insulating layer may be formed by any one of mechanical, laser, and chemical processing. When the through hole is formed by mechanical processing, a method such as milling, drilling and routing may be used, when the through hole is formed by laser processing, a method of UV or CO₂ laser may be used, when the through hole is formed by chemical processing, a chemical including amino silane, ketones, or the like may be used. Accordingly, at least one insulating layer among the plurality of insulating layers may be opened.

Meanwhile, the laser processing is a cutting method in which a part of a material is melted and evaporated by concentrating optical energy at a surface to take a desired shape. In addition, the laser processing can easily process complex shapes using computer programs, and it can also process composite materials that are difficult to cut with other methods.

In addition, the laser processing has the advantage that the cutting diameter is possible up to a minimum of 0.005 mm and a thickness range that can be processed is wide.

As the laser processing drill, it is preferable to use a YAG (Yttrium Aluminum Garnet) laser, a CO2 laser, or an ultraviolet (UV) laser. The YAG laser is a laser that can process both the copper foil layer and the insulating layer, and the CO2 laser is a laser that can only process the insulating layer.

When the through hole is formed, the through electrode may be formed by filling the inside of the through hole with a conductive material. The metal material forming the through electrode may be any one selected from among copper (Cu), silver (Ag), tin (Sn), gold (Au), nickel (Ni), and palladium (Pd). In addition, the conductive material may be filled by any one of electroless plating, electroplating, screen printing, sputtering, evaporation, ink jetting, and dispensing, or a combination thereof.

The second substrate layer 300 may have a multiple layer structure. To this end, the second substrate layer 300 may include a plurality of second insulating layers. For example, the second substrate layer 300 may include a second-first insulating layer 311, a second-second insulating layer 312, a second-third insulating layer 313, and a second-fourth insulating layer 314.

For example, the second substrate layer 300 may include a second insulating layer of four-layer. However, the embodiment is not limited to this, and the second insulating layer constituting the second substrate layer 300 may include a second insulating layer of 3 or less layers, or may include a second insulating layer of 4 or more layers.

The second-first insulating layer 311 may be disposed on the first substrate layer 200. For example, the second-first insulating layer 311 may be disposed on the upper surface of the first-first insulating layer 211 disposed on the uppermost side of the first substrate layer 200.

The second-second insulating layer 312 may be disposed on the second-first insulating layer 311.

Additionally, the second-third insulating layer 313 may be disposed on the second-second insulating layer 312.

Additionally, the second-fourth insulating layer 314 may be disposed on the second-third insulating layer 313.

The second insulating layer of four layer constituting the second substrate layer 300 may include the same insulating material as the first insulating layer constituting the first substrate layer 200, but is not limited thereto.

The second substrate layer 300 may include a second circuit pattern layer.

For example, the second substrate layer 300 may include a fifth circuit pattern 321 disposed on the upper surface of the second-first insulating layer 311.

For example, the second substrate layer 300 may include a sixth circuit pattern 322 disposed on the upper surface of the second-second insulating layer 312.

For example, the second substrate layer 300 may include a seventh circuit pattern 323 disposed on the upper surface of the second-third insulating layer 313.

Additionally, the second substrate layer 300 may include an eighth circuit pattern 324 disposed on the upper surface of the second-fourth insulating layer 314.

At this time, the second circuit pattern layer constituting the second substrate layer 300 may be a conductive antenna pattern layer. For example, the fifth circuit pattern 321, the sixth circuit pattern 322, the seventh circuit pattern 323, and the eighth circuit pattern 324 may be an antenna part that is connected to the first substrate layer 200 and functions as an antenna that transmits a transmission signal to the outside or receives a signal transmitted from the outside.

The conductive antenna pattern layer may be formed through the same process as the first circuit pattern layer constituting the first substrate layer 200.

The second substrate layer 300 may include a through electrode.

For example, the second substrate layer 300 may include a through electrode that passes through the second insulating layer.

For example, the second substrate layer 300 may include a fourth through electrode 331 that passes through the second-first insulating layer 311. The fourth through electrode 331 may electrically connect the first circuit pattern 221 of the first substrate layer 200 and the fifth circuit pattern 321.

For example, the second substrate layer 300 may include a fifth through electrode 332 that passes through the second-second insulating layer 312. For example, the fifth through electrode 332 may electrically connect the fifth circuit pattern 321 and the sixth circuit pattern 322.

For example, the second substrate layer 300 may include a sixth through electrode 333 that passes through the second-third insulating layer 313. The sixth through electrode 333 may electrically connect the sixth circuit pattern 322 and the seventh circuit pattern 323.

For example, the second substrate layer 300 may include a seventh through electrode 334 that passes through the second-fourth insulating layer 314. The seventh through electrode 334 may electrically connect the seventh circuit pattern 323 and the eighth circuit pattern 334.

Meanwhile, the second substrate layer 300 includes a cavity C.

Accordingly, the second substrate layer 300 may include a region where the cavity C is formed, for example, a third region RT1 that overlaps the cavity C in a vertical direction, and a fourth region RT2 other than the third region RT1.

The third region RT1 may be a region that overlaps the first region (RB1) of the first substrate layer 200 a vertical direction. The fourth region RT2 may be a region that overlaps the second region (RB2) of the first substrate layer 200 in the vertical direction.

Additionally, in the antenna package substrate, a cavity C may be formed in the third region RT1 of the second substrate layer 300 to provide a mounting space for a driving device or passive devices to be mounted. Additionally, a conductive antenna pattern layer of an antenna part that functions as an antenna may be formed in the fourth region RT2 of the second substrate layer 300.

For example, the third region RT1 of the second substrate layer 300 is a region where the cavity C is formed, and the fourth region RT2 of the second substrate layer 300 is a region excluding the region where the cavity C is formed. And, the fourth region RT2 of the second substrate layer 300 is a region where a conductive antenna pattern layer is formed.

At this time, each circuit pattern in the circuit board 100 of the present application is disposed in the first to fourth regions of the first substrate layer 200 and the second substrate layer 300, respectively, and accordingly, each region can perform different functions.

For example, the first circuit pattern layer constituting the first substrate layer 200 may include a first pattern portion disposed in the first region (RB1) of the first substrate layer 200. In addition, the first pattern portion may overlap in the vertical direction with the cavity C. The first pattern portion may function as a mounting pattern on which a driving device or a passive element is placed, or a terminal pattern connecting the circuit board 100 and an external board (for example, the main board of a terminal).

Additionally, the first circuit pattern layer constituting the first substrate layer 200 may include a second pattern portion disposed in the second region RB2 of the first substrate layer 200. Also, the second pattern portion may not vertically overlap the cavity C. For example, the second pattern portion may vertically overlap a conductive antenna pattern layer formed in the fourth region RT2 of the second substrate layer 300.

At this time, in one embodiment, the second pattern portion may function as a terminal pattern together with the first pattern portion. And, when the second pattern portion functions as a terminal pattern together with the first pattern portion, the circuit board of the embodiment may function as an antenna only in the fourth region RT2 of the second substrate layer 300. For example, when the second pattern portion is not a conductive antenna pattern layer, the circuit board of the embodiment may transmit a transmission signal to the upper side of the fourth region RT2 of the second substrate layer 300, or may receive a signal transmitted from the upper side of the fourth region RT2.

Additionally, in another embodiment, the second pattern portion may be another conductive antenna pattern layer connected to the conductive antenna pattern layer disposed in the fourth region RT2 of the second substrate layer 300.

For example, the conductive antenna pattern layer disposed in the fourth region RT2 of the second substrate layer 300 may be referred to as a first antenna pattern layer. Additionally, the second pattern portion disposed in the second region (RB2) of the first substrate layer 200 may be a second antenna pattern layer connected to the first antenna pattern layer.

In this case, the embodiment may transmit signals in both directions of the circuit board or receive signals transmitted from both directions of the circuit board. For example, in the embodiment, a signal may be transmitted in a direction above the first antenna pattern layer, and a signal may be transmitted in a direction below the second antenna pattern layer. Additionally, the embodiment may receive a signal transmitted from the upper side of the first antenna pattern layer, and may receive a signal transmitted from the lower side of the second antenna pattern layer.

Meanwhile, in the embodiment, the first pattern portion disposed in the first region (RB1) of the first substrate layer 200 is said to function as a mounting pad or terminal pad, but the embodiment is not limited thereto. For example, some of the first pad portions disposed in the first region (RB1) of the first substrate layer 200 may function as mounting pads or terminal pads, and the remaining part may function as an antenna pattern together with the second antenna pattern layer.

Hereinafter, a structure of the cavity C of the embodiment will be described in detail.

Referring to FIG. 3aA, the cavity C of the embodiment is formed passing through the second substrate layer 300. For example, the cavity C is formed to pass through a plurality of second insulating layers constituting the second substrate layer 300.

At this time, the cavity C may include a plurality of parts.

For example, the cavity C may include a first part P1 adjacent to the upper surface of the second substrate layer 300. Additionally, the cavity C may include a second part adjacent to the lower surface of the second substrate layer 300 and disposed below the first part P1.

At this time, the first part P1 may have a first inclination whose width gradually decreases toward the lower surface of the second substrate layer 300. The first inclination may mean an inclination of an inner wall IW1 of the first part P1. For example, the first inclination may mean an inclination angle of the inner wall IW1 of the first part P1 with respect to a bottom surface of the cavity C. For example, the first inclination may mean an internal angle between the bottom surface of the cavity C and the inner wall IW1 of the first part P1.

The first inclination θ1 of the inner wall IW1 of the first part P1 may range between 115 degrees and 150 degrees. For example, the first inclination θ1 of the inner wall IW1 of the first part P1 may range between 118 degrees and 148 degrees. For example, the first inclination θ1 of the inner wall IW1 of the first part P1 may range between 120 degrees and 145 degrees.

If the first inclination θ1 of the inner wall IW1 of the first part P1 is less than 115 degrees, a process time required to form the cavity C according to the embodiment may increase. For example, the fact that the first inclination θ1 of the inner wall IW1 of the first part P1 is less than 115 degrees means that the laser beam width (e.g., laser mask) used in a process of forming a primary cavity described below is small, and accordingly, the time required to form the cavity C may increase.

In addition, if the first inclination θ1 of the inner wall IW1 of the first part P1 is greater than 150, circuit integration may decrease as a width of the upper portion of the cavity C increases. For example, a process of forming a cavity is performed based on a lower width of the cavity C determined to correspond to an arrangement space of the device to be mounted. At this time, if an upper width of the cavity C increases, this means that the amount of space wasted pointlessly increases. Accordingly, the space in which the antenna pattern layer can be placed may decrease as the upper width increases. Accordingly, in the embodiment, the first inclination θ1 of the inner wall IW1 of the first part P1 has a range between 115 degrees and 150 degrees.

Meanwhile, the cavity C of the embodiment includes a second part P2 below the first part P1. The second part P2 may have a second inclination θ2 whose width gradually decreases toward the lower surface of the second substrate layer 300. At this time, the second inclination θ2 of the second part P2 may be different from the first inclination θ1 of the first part P1. For example, the second inclination θ2 of the second part P2 may be smaller than the first inclination θ1 of the first part P1.

At this time, the second inclination θ2 may mean an inclination of the inner wall IW2 of the second part P2. For example, the second inclination θ2 may mean an inclination of the inner wall IW2 of the second part P2 with respect to the bottom surface of the cavity C. For example, the second inclination θ2 may mean an internal angle between the bottom surface of the cavity C and the inner wall IW2 of the second part P2.

The second inclination θ2 of the inner wall IW2 of the second part P2 is smaller than the first inclination θ1 and may range between 91 degrees and 120 degrees. For example, the second inclination θ2 of the inner wall IW2 of the second part P2 is smaller than the first inclination θ1 and may range between 95 degrees and 118 degrees. For example, the second inclination θ2 of the inner wall IW2 of the second part P2 is smaller than the first inclination θ1 and may range between 98 degrees and 115 degrees.

If the second inclination θ2 of the inner wall IW2 of the second part P2 is less than 91 degrees, the driving device or passive device may not be stably placed in the cavity C. For example, if the second inclination θ2 of the inner wall IW2 of the second part P2 is less than 91 degrees, the second part P2 may have a shape whose width decreases toward the upper surface of the second substrate layer 300, and there may not be space for a driving device or passive device to be placed in the middle region of the cavity C. For example, the inner wall in the middle region of the cavity C may contact a driving device or a passive device, and accordingly, the position of the driving device or passive device may be distorted during the mounting process of the driving device or passive device. That is, as described above, the width of the cavity C is determined based on a width of a lower portion of the cavity C in accordance with a device mounting space. At this time, if the second inclination θ2 of the inner wall IW2 of the second part P2 is less than 91 degrees, a space narrower than the device mounting space may exist toward the upper side of the second part P2, and accordingly, there is a problem in which passive devices or driving devices cannot be stably mounted in the cavity C.

In addition, if the second inclination θ2 of the inner wall IW2 of the second part P2 is greater than 120 degrees, the cavity C may be formed to have a size greater than the space required for the device mounting space. Accordingly, if the second inclination θ2 of the inner wall IW2 of the second part P2 is greater than 120 degrees, an area of the space occupied by the cavity C may increase even if the same elements are disposed, and thus the circuit integration degree may decrease.

Meanwhile, lengths of the first part P1 and the second part P2 of the cavity C may be different from each other. For example, the first part P1 of the cavity C may have a first length L1, and the second part P2 may have a second length L2 longer than the first length L1. At this time, the first length L1 may mean a depth of the first part P1. For example, the first length L1 may mean a vertical distance of the first part P1 in a vertical direction. Additionally, the second length L2 may mean a depth of the second part P2. For example, the second length L2 may mean a vertical distance of the second part P2 in the vertical direction.

At this time, the second length L2 may be 1.5 times or more than the first length L1. For example, the second length L2 may be three times or more than the first length L1. For example, the second length L2 may be 5 times or more than the first length L1. For example, the second length L2 may be 10 times or more than the first length L1.

For example, the second length L2 may satisfy a range of 1.5 to 30 times the first length L1. For example, the second length L2 may satisfy a range of 3 to 28 times the first length L1. For example, the second length L2 may satisfy a range of 5 to 25 times the first length L1. For example, the second length L2 may satisfy a range of 10 to 20 times the first length L1.

At this time, if the second length L2 is less than 1.5 times the first length L1, the effect resulting from a difference between the first inclination of the first part P1 and the second inclination of the second part P2 may be insignificant. In addition, if the second length L2 is 30 times or more than the first length L1, the thickness of the second substrate layer 300 increases to satisfy this, and thus the overall thickness of the circuit board may increase.

Meanwhile, the cavity C of the embodiment may include a third part P3 below the second part P2. The third part P3 may be positioned lower than the second substrate layer 300. For example, the cavity passing through the second substrate layer 300 includes the first part P1 and the second part P2, and the third part P3 may be a space formed by removing a portion of the first substrate layer 200, rather than the second substrate layer 300.

For example, the third part P3 may be a portion formed by removing a stopper layer disposed in a region that vertically overlaps the cavity (C) among the first circuit patterns 221 disposed on an uppermost side of the first substrate layer 200.

For example, a total depth of the cavity C may be greater than a total thickness of the second insulating layer constituting the second substrate layer 300. For example, a depth of the cavity C may be as great as the thickness of the first circuit pattern 221 compared to the thickness of the second insulating layer.

Accordingly, a bottom surface of the cavity C may be positioned lower than the bottom surface of the second substrate layer 300.

The third part P3 may have a third inclination. The third inclination may mean an inclination of an inner wall IW3 of the third part P3. At this time, the inner wall IW1 of the first part P1 and the inner wall IW2 of the second part P2 refer to the inner wall of the second insulating layer constituting the second substrate layer 300. In contrast, the inner wall IW3 of the third part P3 may mean an inclination of a side surface of the first-third pattern 221-3 in the first circuit pattern 221 of the first substrate layer 200.

For example, in an embodiment, the first circuit pattern 221 of the first substrate layer 200 includes a first-third pattern 221-3 disposed surrounding a bottom portion of the cavity C. The first-third pattern 221-3 may be a portion of a stopper layer used in a process of forming the cavity C. For example, it is difficult to form the cavity C with a lower width corresponding to the stopper layer, and accordingly, the lower width of the cavity C may be smaller than the width of the stopper layer. Additionally, the stopper layer that does not vertically overlap the cavity (C) may not be removed during a process of the etching and may remain as a first-third pattern 221-3 between the first substrate layer 200 and the second substrate layer 300. The inner wall (IW3) of the third part (P3) of the cavity (C) may have an inclination angle of a side surface of the first-third pattern 221-3. The third inclination of the inner wall (IW3) of the third part (P3) may be determined by an etching condition of the stopper layer.

For example, in a first embodiment, the third inclination of the inner wall (IW3) of the third part P3 may be perpendicular to the bottom surface of the cavity C.

Meanwhile, in an embodiment, the upper surface of the first substrate layer 200 may have a step difference. For example, the first substrate layer 200 includes a first insulating layer. Additionally, the upper surface of the first insulating layer may have a step difference. For example, the first substrate layer 200 includes a plurality of first insulating layers, and the upper surface of the first-first insulating layer disposed on the uppermost side of the plurality of first insulating layers may have a step difference.

For example, the upper surface of the first-first insulating layer 211 may include a first upper surface 211 T1 that vertically overlaps the cavity C, and a second upper surface 211T2 other than the first upper surface 211T1. For example, the first upper surface 211T1 of the first-first insulating layer 211 may mean a first region RB1 of the first substrate layer 200. For example, the second upper surface 211 T2 of the first-first insulating layer 211 may mean a second region RB2 of the first substrate layer 200.

Also, the first upper surface 211 T1 of the first-first insulating layer 211 may be positioned lower than the second upper surface 211T2 of the first-first insulating layer 211. For example, the first upper surface 211T1 of the first-first insulating layer 211 may be positioned lower than the second upper surface 211T2 by removing the stopper layer in the region that overlaps vertically with the cavity C. For example, the first upper surface 211T1 of the first-first insulating layer 211 may be positioned lower than the second upper surface 211T2 by the thickness of the stopper layer. At this time, the first upper surface 211T1 of the first-first insulating layer 211 may mean the bottom surface of the cavity C.

Accordingly, the first circuit pattern 221 disposed on the upper surface of the first-first insulating layer 211 may have different heights for each region. For example, the first circuit pattern 221 may include a first-first pattern 221-1 disposed on the first upper surface 211T1 of the first-first insulating layer 211. Additionally, the first circuit pattern 221 may include a first-second pattern 221-2 disposed on the second upper surface 211T2 of the first-first insulating layer 211. Also, the first-first pattern 221-1 may be positioned lower than the first-second pattern 221-2. For example, the upper surface of the first-first pattern 221-1 may be positioned lower than the upper surface of the first-second pattern 221-2.

Additionally, in an embodiment, the first through electrode 231 may have different thicknesses depending on an arrangement position. For example, the first through electrode 231 may include a first-first through electrode 231-1 that vertically overlaps the first-first pattern 221-1. Additionally, the first through electrode 231 may include a first-second through electrode 231-2 that vertically overlaps the first-second pattern 221-2. Additionally, a thickness of the first-first through electrode 231-1 may be thinner than a thickness of the first-second through electrode 231-2. For example, the thickness of the first-first through electrode 231-1 may be as thin as the thickness of the stopper layer compared to the thickness of the first-second through electrode 231-2. Through this, the circuit board of the embodiment can be implemented with a thin thickness.

Meanwhile, referring to FIG. 3b, the cavity C may include a first part P1, a second part P2, and a third part P3a. At this time, the third inclination of the third part P3a in a cavity of FIG. 3b is different compared to the cavity of FIG. 3a. For example, an inclination of the side surface of the first-third pattern 221-3 in FIG. 3a is substantially perpendicular to the bottom surface of the cavity C. Unlike this, referring to FIG. 3b, a third inclination of a side surface IW3a of the first-third pattern 221-3a may have a certain inclination with respect to the bottom surface of the cavity. For example, the third inclination may be the same as the second inclination of the inner wall IW2 of the second part P2. For example, the third inclination may be different from the second inclination. At this time, the third inclination may be selectively changed depending on the etching conditions of the stopper layer.

Additionally, referring to FIG. 3c, the cavity C may include a first part P1, a second part P2, and a third part P3b. At this time, the cavity of FIGS. 3A and 3B has a structure in which the first-third pattern 221-3 is disposed in a region adjacent to the bottom surface of the cavity C.

Alternatively, as shown in FIG. 3C, the first-third pattern can be completely removed during etching. Accordingly, a recess IW3ab may be formed at the inner wall of the third part P3b of the cavity C and may be recessed in a direction away from the cavity C.

According to an embodiment, the circuit board includes a first substrate layer and a second substrate layer. The second substrate layer includes a cavity. Additionally, the first substrate layer includes a first region vertically overlapping the cavity and a second region excluding the first region. Additionally, the second substrate layer includes a third region corresponding to the cavity and a fourth region excluding the third region. At this time, the third region of the second substrate layer in the embodiment is a region where the driving device is mounted, and the fourth region is a region where the antenna pattern layer is disposed. In the above embodiment, the antenna pattern layer is disposed in the fourth region of the second substrate layer horizontally adjacent to the driving device while mounting the driving device using the cavity of the second substrate layer. Accordingly, the embodiment can minimize a signal transmission distance between the antenna pattern layer and the driving device, and thereby minimize signal transmission loss. For example, the embodiment can reduce the signal transmission distance compared to a comparative example in which a substrate on which the driving device is disposed and a substrate on which the antenna pattern layer is disposed are connected using a separate connection means, and accordingly, signal transmission loss caused by a separate connection means can be reduced. In addition, the embodiment provides a structure in which the antenna pattern layer and the driving device are disposed in the horizontal direction, and accordingly, the second region of the first substrate layer that vertically overlaps the fourth region of the second substrate layer can be used as a second antenna pattern layer, and furthermore, it is possible to enable antenna pattern radiation and signal reception in different directions from one circuit pattern.

Additionally, the embodiment can reduce an overall thickness of the circuit board to correspond to a depth of the cavity by mounting the driving device in the cavity of the second substrate layer.

Additionally, the cavity of the embodiment includes a first part with a first inclination and a second part with a second inclination different from the first inclination. At this time, with respect to the bottom surface of the cavity, the second inclination has a smaller inclination angle than the first inclination. Additionally, a vertical length of the second part having the second inclination in the embodiment is longer than a vertical length of the first part having the first inclination. Accordingly, the embodiment can reduce a space occupied by the cavity compared to the comparative example, and thus improve circuit integration. For example, the embodiment can reduce the space occupied by the cavity and increase the length of the antenna pattern layer in a substrate having a same size as the comparative example, thereby improving communication performance.

In addition, the first substrate layer of the embodiment includes a first-first insulating layer disposed closest to the first substrate layer, and a first circuit pattern disposed on the upper surface of the first-first insulating layer. At this time, the first circuit pattern includes a first-first pattern formed in a first region vertically overlapping the cavity, and a first-second pattern formed in the second region excluding the first region. An upper surface of the first-first pattern is positioned lower than an upper surface of the first-second pattern. Accordingly, the embodiment can prevent the surface of the first-first pattern from being damaged in the laser process for forming the cavity, and thus improve the electrical and physical reliability of the circuit board.

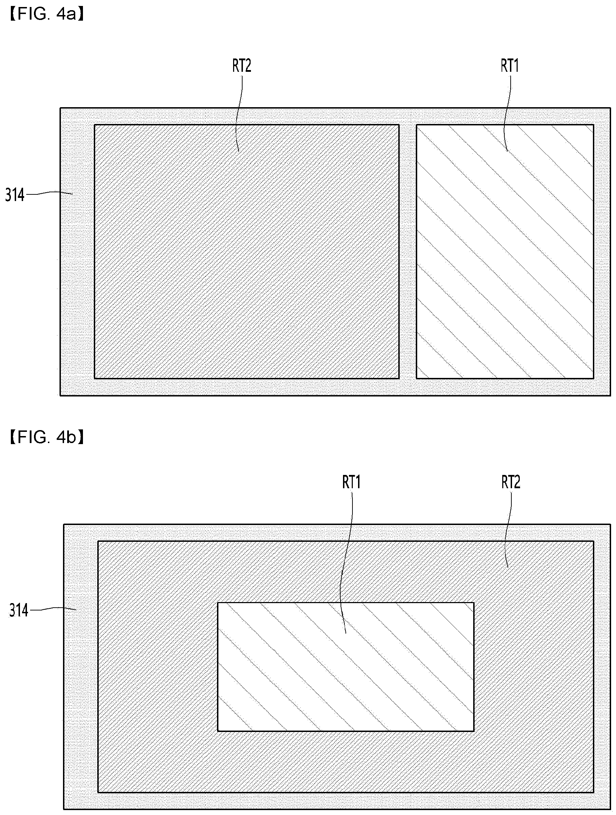

FIGS. 4a and 4b are plan views of a second substrate layer viewed from a top.

Referring to FIG. 4a, the second substrate layer 300 includes a third region RT1 and a fourth region RT2. And, the third region RT1 is a region in which a cavity C passing through the second substrate layer 300 is formed. At this time, the third region RT1 and the fourth region RT2 may be formed in the width or length direction of the second substrate layer 300, respectively. For example, the third region RT1 may be positioned at one side of the fourth region RT2.

Unlike this, referring to FIG. 4b, the third region RT1 may be positioned at a center of the second substrate layer 300. Additionally, the fourth region RT2 may be formed to surround the third region RT1.

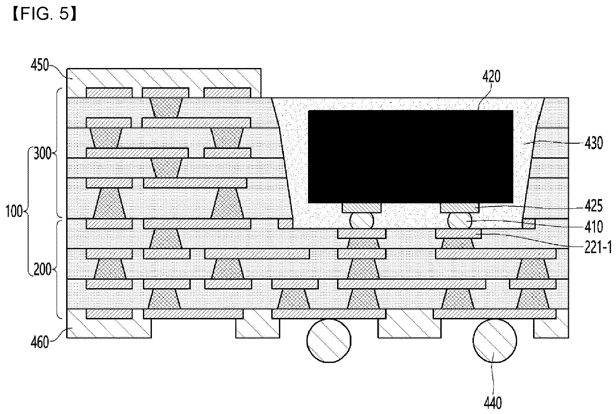

FIG. 5 is a view showing an antenna package substrate according to an embodiment.

Referring to FIG. 5, an antenna package substrate includes the circuit board 100 shown in FIG. 2.

Additionally, the antenna package substrate may include a first protective layer 450 disposed on an upper surface of the second substrate layer 300 of the circuit board 100. Additionally, the antenna package substrate may include a second protective layer 460 disposed under the lower surface of the first substrate layer 200 of the circuit board 100.

Additionally, the antenna package substrate may include a first connection part 410 disposed on the first-first circuit pattern 221-1 disposed in a region vertically overlapping with the cavity C among the first circuit patterns 221 of the first substrate layer 200. A planar shape of the first connection part 410 may be circular. Alternatively, a planar shape of the first connection part 410 may be square. The first connection part 410 may be disposed on the first-first circuit pattern 221-1 and can connect between the first-first circuit pattern 221-1 and the terminal 425 of the device 420. For example, the first connection part 410 may be a solder ball. The first connection part 410 may contain a heterogeneous material in solder. The solder may be composed of at least one of Sn-Cu, Sn-Pb, and Sn-Ag-Cu. And, the heterogeneous material may include any one of Al, Sb, Bi, Cu, Ni, In, Pb, Ag, Sn, Zn, Ga, Cd, and Fe.

A device 420 is disposed on the first connection part 410. The device 420 may be a driver device. For example, the device 420 may be a driving device that drives the antenna pattern layer included in the circuit board. Additionally, in the drawing, it is shown that only one device is mounted in the cavity C, but this is not limited. For example, a passive device (not shown) for operating the device 420 may be additionally mounted in the cavity C in addition to the device 420.

Meanwhile, a molding layer 430 may be formed within the cavity C, covering the device 420. The molding layer 430 may be EMC (Epoxy Molding Compound), but is not limited thereto.

Additionally, the embodiment includes a second connection part 440 disposed under the lower surface of the circuit pattern layer disposed under the lower surface of the first region RB1 of the first substrate layer 200. The second connection part 440 may connect the antenna package substrate and an external substrate (e.g., the main board of the terminal).

Hereinafter, a method of manufacturing a circuit board according to an embodiment will be described in order of process.

At this time, the circuit board of the embodiment may have a coreless structure as shown in FIG. 2.

However, the embodiment is not limited to this. For example, the circuit board of the embodiment may be a core board including a core insulating layer. For example, the circuit board in the embodiment may have an Embedded Trace Substrate (ETS) structure manufactured using the ETS (Embedded Trace Substrate) method. However, the embodiment will be described assuming that the circuit board has a coreless board structure for convenience of explanation.

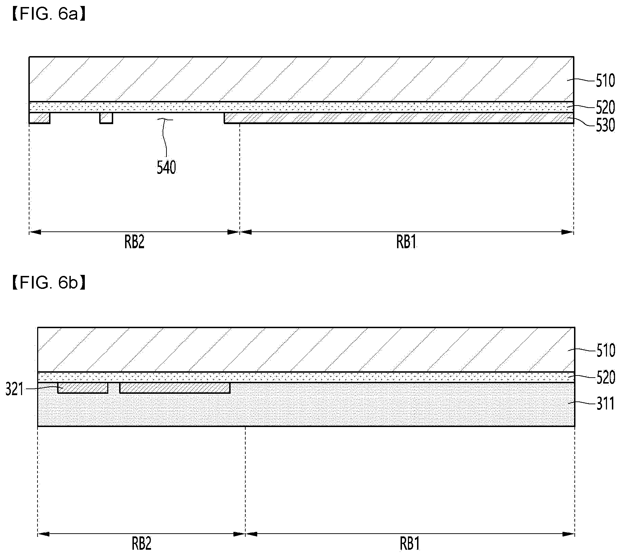

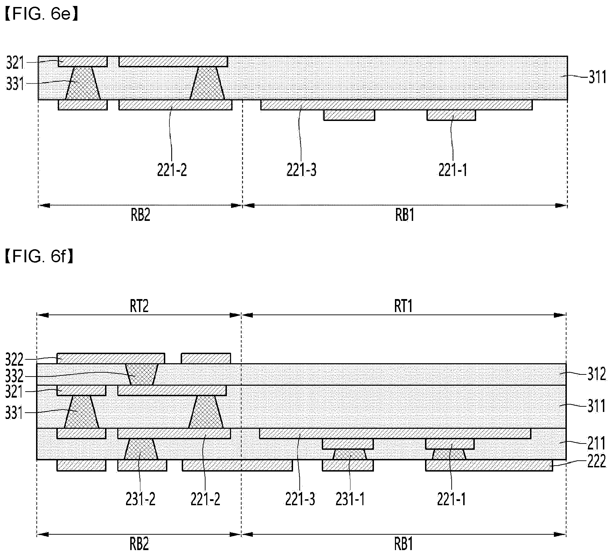

FIGS. 6a to 6o are diagrams showing a method for manufacturing a circuit board according to an embodiment shown in FIG. 2 in order of process.

The manufacturing process of the circuit board according to the embodiment of the present application may broadly include a first process of manufacturing a part of the first substrate layer and a part of the second substrate layer using a carrier board, a process of manufacturing the remaining part of the first substrate layer and the remaining part of the second substrate layer above and below the substrate layer manufactured through the first process, respectively, a process of forming a cavity in the second substrate layer, and a process of removing the stopper layer from a region vertically overlapping the cavity.

First, referring to FIG. 6a, a carrier board, which is a basic material for manufacturing a circuit board according to an embodiment, can be prepared.

The carrier board may include a carrier insulating layer 510 and a carrier copper foil layer 520 disposed on one surface of the carrier insulating layer 510.

The carrier copper foil layer 520 may be disposed on one side of the carrier insulating layer 510, or alternatively, may be disposed on both sides. If the carrier copper foil layer 520 is disposed on both sides of the carrier insulating layer 510, the process of manufacturing the circuit board may be performed on both sides of the carrier board until the carrier board is removed in the following process.

The carrier copper foil layer 520 may be formed by performing electroless plating on the surface of the carrier insulating layer 510. Alternatively, the carrier insulating layer 510 and the carrier copper foil layer 520 may be copper clad laminate (CCL).

At this time, the carrier board may include a first region (RB1) and a second region (RB2) of the first substrate layer 200.

Next, the embodiment may proceed with a process of forming a mask 530 on the lower surface of the carrier copper foil layer 520. At this time, the embodiment may proceed with a process of forming an opening 540 in the mask 530. The opening 540 of the mask 530 may vertically overlap a region on the lower surface of the carrier copper foil layer 520 where the fifth circuit pattern 321 will be formed.

Next, as shown in FIG. 6b, the embodiment may proceed with a process of forming the fifth circuit pattern 321 that fills the opening 540 of the mask 530 by performing electrolytic plating using the carrier copper foil layer 520 as a seed layer.

And, when the fifth circuit pattern 321 is formed, the embodiment may proceed with a process of removing the mask 530. Next, when the mask 530 is removed, the embodiment may proceed with a process of forming a second-first insulating layer 311, which is part of the second insulating layer of the second substrate layer 300, on the lower surface of the carrier copper foil layer 520 and the lower surface of the fifth circuit pattern 321.

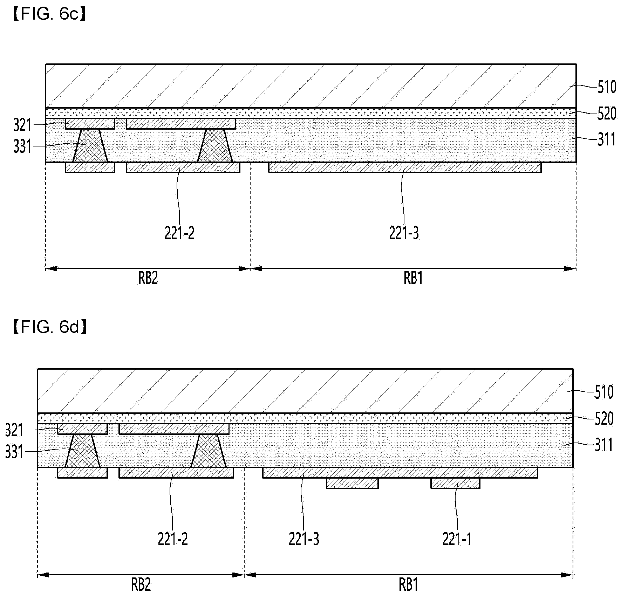

Next, as shown in FIG. 6c, the embodiment may proceed with a process of forming a through hole (not shown) passing through the second-first insulating layer 311. Next, the embodiment may proceed with a process of forming a fourth through electrode (331) filling the through hole of the second-first insulating layer 311 and a process of forming a portion of the first circuit pattern 221 of the first substrate layer 200 on the lower surface of the second-first insulating layer 311.

At this time, the first circuit pattern 221 may include a first-second pattern 221-2 vertically overlapping with the second region RB2 on the lower surface of the second-first insulating layer 311, and a stopper layer 221-3 that vertically overlaps the first region RB1. The stopper layer 221-3 may be formed in a region on the lower surface of the second-first insulating layer that vertically overlaps the region where the cavity is to be formed.

Next, as shown in FIG. 6d, the embodiment may proceed with a process of forming the first-first pattern 221-1, which is the remaining part of the first circuit pattern 221, on the lower surface of the stopper layer 221-3.

At this time, the first-first pattern 221-1 may be disposed on the lower surface of the stopper layer 221-3, and may have a step difference (for example, different height) from the first-second pattern 221-2 formed in the second region (RB2) of the lower surface of the second-first insulating layer 311.

Next, as shown in FIG. 6e, the embodiment may proceed with a process of removing the carrier insulating layer 510 and the carrier copper foil layer 520.

Thereafter, the embodiment may proceed with a process of manufacturing a portion of the second substrate layer 300 and a portion of the first substrate layer 200 at the upper and lower portions of the second-first insulating layer 311, respectively. For example, the embodiment includes a process of forming a first-first insulating layer 211 on the lower surface of the second-first insulating layer 311, a process of forming a first through electrode 231 passing through the first-first insulating layer 211, and a process of forming a second circuit pattern 222 on the lower surface of the first-first insulating layer 211. At this time, the first through electrode 231 may include a first-first through electrode (231-1) connected to the first-first pattern (221-1), and a first-second through electrode (231-2) connected to the first-second pattern (221-2). Additionally, the first-first through electrode 231-1 and the first-second through electrode 231-2 may have different thicknesses. Specifically, the first-first pattern 221-1 is located lower than the first-second pattern 221-2. Accordingly, a thickness of the first-first through electrode 231-1 may be thinner than a thickness of the first-second through electrode 231-2. For example, a lower surface of the first-first through electrode 231-1 may be positioned on the same plane as a lower surface of the first-second through electrode 231-2. In contrast, an upper surface of the first-first through electrode 231-1 may be positioned lower than an upper surface of the first-second through electrode 231-2.

Additionally, the embodiment may proceed with a process of forming a second-second insulating layer (312) on the upper surface of the second-first insulating layer (311), a process of forming a fifth through electrode (332) passing through the second-second insulating layer (312), and a process of forming a sixth circuit pattern 322 on the upper surface of the second-second insulating layer 312.

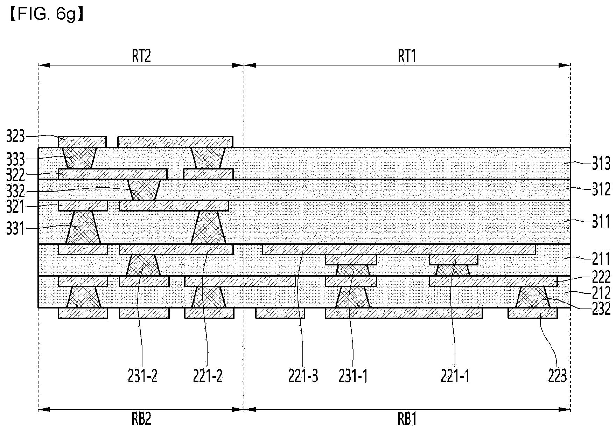

Additionally, as shown in FIG. 6g, the embodiment may proceed with a process of forming a first-second insulating layer 212 on the lower surface of the first-first insulating layer 211. In addition, the embodiment may proceed with a process of forming a second through electrode 232 passing through the first-second insulating layer 212 and a process of forming a third circuit pattern 223 on the lower surface of the first-second insulating layer 212.

Additionally, the embodiment may proceed with a process of forming a second-third insulating layer 313 on the upper surface of the second-second insulating layer 312. In addition, the embodiment may proceed with a process of forming a sixth through electrode 333 passing through the second-third insulating layer 313 and a process of forming a seventh circuit pattern 323 on the upper surface of the second-third insulating layer 313.

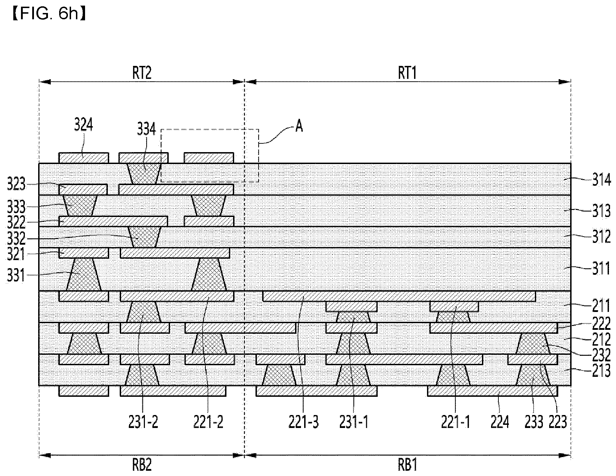

Next, as shown in FIG. 6h, the embodiment may proceed with a process of forming the first-third insulating layer 213 on the lower surface of the first-second insulating layer 212. In addition, the embodiment may proceed with a process of forming a third through electrode 233 passing through the first-third insulating layer 213 and a process of forming a fourth circuit pattern 224 on the lower surface of the first-third insulating layer 213.

Additionally, the embodiment may proceed with a process of forming a second-fourth insulating layer 314 on the upper surface of the second-third insulating layer 313. Next, the embodiment may proceed with a process of forming a seventh through electrode 334 passing the second-fourth insulating layer 314 and an eighth circuit pattern 324 on the second-fourth insulating layer 314.

Through this, in the embodiment, manufacturing of the circuit board 100 including the first substrate layer 200 and the second substrate layer 300 before the cavity C is formed can be completed.

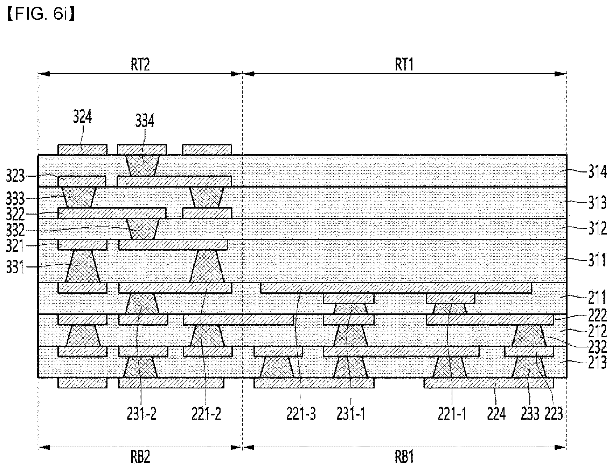

Meanwhile, as shown in FIG. 6i, the embodiment allows the seed layer of the eighth circuit pattern 324 to remain without removing part of it in the process of forming the eighth circuit pattern 324. In addition, this can be used as a mask in a process of forming the cavity (C).

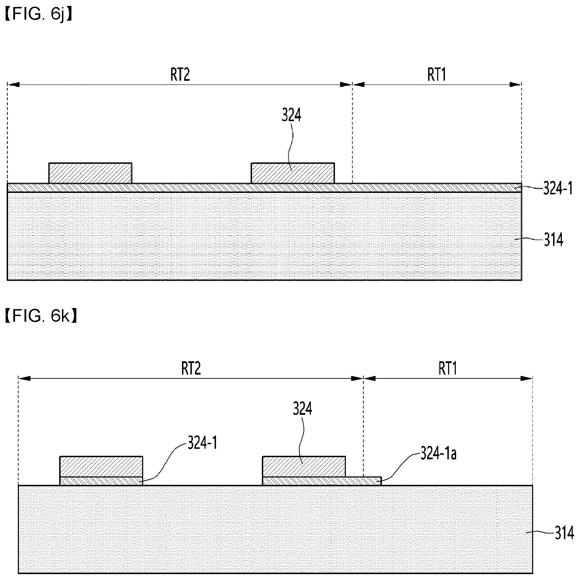

For example, as shown in FIG. 6j, looking at the manufacturing process of the eighth circuit pattern 324, a seed layer 324-1 for forming the eighth circuit pattern 324 is located on the upper surface of the second-fourth insulating layer 314. Additionally, the seed layer 324-1 may be used as a seed layer for electroplating the eighth circuit pattern 324.

Next, as shown in FIG. 6k, as the eighth circuit pattern 324 is formed, the embodiment may proceed with a process of removing a region of the seed layer 324-1 that does not vertically overlap the eighth circuit pattern 324. At this time, the embodiment allows the seed layer 324-1 to remain in the region 324-1a adjacent to the region where the cavity C is to be formed without being removed. And, in the cavity forming process below, the embodiment proceeds with a process of forming a cavity only on the portion corresponding to the third region (RT1) by using the region (324-1a) of the seed layer (324-1) as a laser mask. At this time, the region RB1 of the seed layer 324-1 may cover a portion of the third region RT1, which is the region where the cavity C will be formed. This may be in consideration of undercut due to process deviation occurring in the laser forming process.

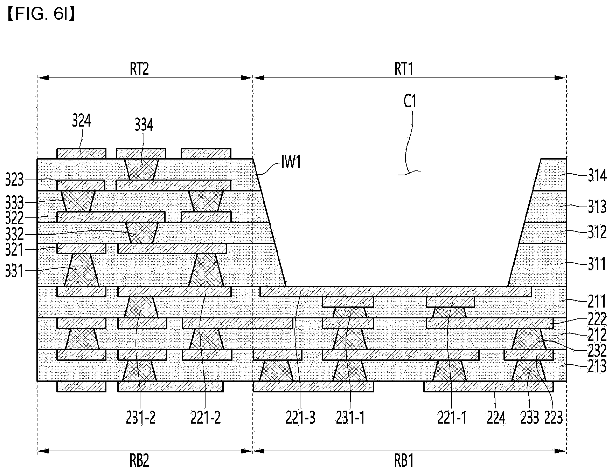

Next, as shown in Figure 6l, the embodiment may proceed with a process of forming a first cavity C1 passing through the second insulating layers of the second substrate layer 300 using the region RB1 of the seed layer 324-1. At this time, the first cavity C1 may be formed up to the upper surface of the stopper layer 221-3, which is part of the first circuit pattern 221 of the first substrate layer 200. At this time, the inner wall (IW1) of the first cavity (C1) may have a first inclination. For example, the embodiment may proceed with a primary cavity process of forming a cavity. At this time, the width of the laser mask in the primary cavity process may have a first width. The laser mask determines a width of a laser beam in a laser equipment. At this time, in the embodiment, the primary cavity process may be performed using a first laser beam having a relatively large width in order to completely open the region where the cavity will be formed. Accordingly, the inner wall (IW1) of the first cavity (C1) formed through the primary cavity process has a first inclination as a whole in response to the first laser beam.

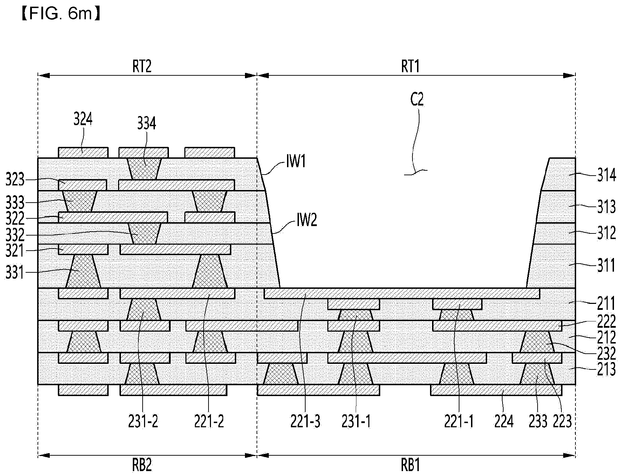

Next, as shown in FIG. 6m, the embodiment may proceed with a process of forming a second cavity C2 by performing a secondary cavity process on the first cavity C1. At this time, a width of the laser mask in the secondary cavity process may have a second width that is smaller than the first width. Additionally, the secondary cavity process may be performed only in a portion corresponding to the inner wall of the first cavity C1 formed in the primary cavity process. The width of the laser mask in the secondary cavity process has a second width smaller than the first width, so that the inner wall of the second cavity C2 may have a plurality of inclinations. For example, the inner wall of the second cavity (C2) may include a first inclination formed by the primary cavity process and a second inclination formed by the secondary cavity process.

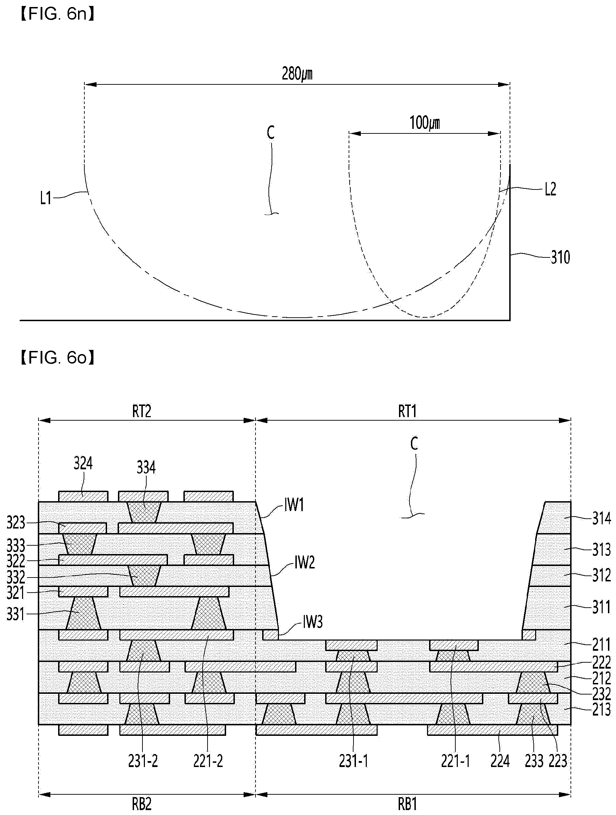

For example, referring to FIG. 6n, the embodiment proceeds with a process of forming the first cavity (C1) by irradiating the first laser beam L1 corresponding thereto using a mask having a first width of 280um. Thereafter, the embodiment may proceed with a process of forming the second cavity (C2) by irradiating the second laser beam L2 corresponding thereto using a mask having a second width of 100 µm, which is smaller than the first width.. Accordingly, the cavity of the embodiment includes a first inclination corresponding to the first laser beam L1 and a second inclination corresponding to the second laser beam L2. At this time, if the inclination of the cavity is to have the second inclination as a whole, the first laser beam L1 penetrates into the lower surface of the region RB1 of the seed layer 324-1 in the first cavity forming process, and thereby forming an undercut region. Also, a portion of the cavity C corresponding to the first inclination may correspond to an undercut region formed in the primary cavity process.

Next, as shown in FIG. 6o, the stopper layer 221-3 exposed through the secondary cavity process can be removed to form the third part of the cavity C. At this time, the inner wall of the third part may be a side surface of the first-third pattern 221-3. At this time, the third part of the cavity C may be formed to have a shape shown in any one of FIGS. 3A to 3C.

According to an embodiment, the circuit board includes a first substrate layer and a second substrate layer. The second substrate layer includes a cavity. Additionally, the first substrate layer includes a first region vertically overlapping the cavity and a second region excluding the first region. Additionally, the second substrate layer includes a third region corresponding to the cavity and a fourth region excluding the third region. At this time, the third region of the second substrate layer in the embodiment is a region where the driving device is mounted, and the fourth region is a region where the antenna pattern layer is disposed. In the above embodiment, the antenna pattern layer is disposed in the fourth region of the second substrate layer horizontally adjacent to the driving device while mounting the driving device using the cavity of the second substrate layer. Accordingly, the embodiment can minimize a signal transmission distance between the antenna pattern layer and the driving device, and thereby minimize signal transmission loss. For example, the embodiment can reduce the signal transmission distance compared to a comparative example in which a substrate on which the driving device is disposed and a substrate on which the antenna pattern layer is disposed are connected using a separate connection means, and accordingly, signal transmission loss caused by a separate connection means can be reduced. In addition, the embodiment provides a structure in which the antenna pattern layer and the driving device are disposed in the horizontal direction, and accordingly, the second region of the first substrate layer that vertically overlaps the fourth region of the second substrate layer can be used as a second antenna pattern layer, and furthermore, it is possible to enable antenna pattern radiation and signal reception in different directions from one circuit pattern.

Additionally, the embodiment can reduce an overall thickness of the circuit board to correspond to a depth of the cavity by mounting the driving device in the cavity of the second substrate layer.

Additionally, the cavity of the embodiment includes a first part with a first inclination and a second part with a second inclination different from the first inclination. At this time, with respect to the bottom surface of the cavity, the second inclination has a smaller inclination angle than the first inclination. Additionally, a vertical length of the second part having the second inclination in the embodiment is longer than a vertical length of the first part having the first inclination. Accordingly, the embodiment can reduce a space occupied by the cavity compared to the comparative example, and thus improve circuit integration. For example, the embodiment can reduce the space occupied by the cavity and increase the length of the antenna pattern layer in a substrate having a same size as the comparative example, thereby improving communication performance.

In addition, the first substrate layer of the embodiment includes a first-first insulating layer disposed closest to the first substrate layer, and a first circuit pattern disposed on the upper surface of the first-first insulating layer. At this time, the first circuit pattern includes a first-first pattern formed in a first region vertically overlapping the cavity, and a first-second pattern formed in the second region excluding the first region. An upper surface of the first-first pattern is positioned lower than an upper surface of the first-second pattern. Accordingly, the embodiment can prevent the surface of the first-first pattern from being damaged in the laser process for forming the cavity, and thus improve the electrical and physical reliability of the circuit board.

The characteristics, structures, effects, and the like described in the above-described embodiments are included in at least one embodiment, but are not limited to only one embodiment. Furthermore, the characteristic, structure, and effect illustrated in each embodiment may be combined or modified for other embodiments by a person skilled in the art. Therefore, it should be construed that contents related to such combination and modification are included in the scope of the embodiment.

Embodiments are mostly described above, but the embodiments are merely examples and do not limit the embodiments, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the embodiment defined in the following claims.

## Claims

1. A circuit board comprising:
a first substrate layer; and
a second substrate layer disposed on the first substrate layer and including a cavity,
wherein the cavity of the second substrate layer includes:
a first part disposed adjacent to an upper surface of the second substrate layer and having a first inclination such that a width gradually decreases toward a lower surface of the second substrate layer; and
a second part disposed below the first part adjacent to the lower surface of the second substrate layer and having a second inclination such that a width gradually decreases toward the lower surface of the second substrate layer,
wherein the first inclination of the first part relative to a bottom surface of the cavity is greater than the second inclination of the second part relative to the bottom surface of the cavity, and
wherein a vertical length of the first part is different from a vertical length of the second part.

2. The circuit board of claim 1, wherein the first inclination of the first part relative to the bottom surface of the cavity ranges between 115 degrees and 150 degrees, and
wherein the second inclination of the second part relative to the bottom surface of the cavity ranges between 91 degrees and 110 degrees.

3. The circuit board of claim 1, wherein the vertical length of the first part is shorter than the vertical length of the second part.

4. The circuit board of any one of claims 1 to 3, wherein the first substrate layer includes:
at least one first insulating layer,
a first circuit pattern layer disposed on the at least one first insulating layer, and
a first through electrode part passing through the at least one first insulating layer,
wherein the second substrate layer includes:
a plurality of second insulating layers,
a second circuit pattern layer disposed on the plurality of second insulating layers, and
a second through electrode part passing through at least one of the plurality of second insulating layers.

5. The circuit board of claim 4, wherein the second circuit pattern layer of the second substrate layer includes a first antenna pattern layer.

6. The circuit board of claim 5, wherein the first substrate layer includes:
a first region overlapping with the cavity in a vertical direction, and
a second region other than the first region,
wherein an upper surface of the first region of the first substrate layer has a step difference from an upper surface of the second region of the first substrate layer, and
wherein the bottom surface of the cavity is positioned lower than a lower surface of the second substrate layer.

7. The circuit board of claim 6, wherein a first circuit pattern layer formed in the second region of the first substrate layer includes a second antenna pattern layer connected to the first antenna pattern layer.

8. The circuit board of claim 4, wherein the first insulating layer includes a first-first insulating layer disposed closest to the second substrate layer, and
wherein an upper surface of the first-first insulating layer includes:
a first upper surface overlapping the cavity in a vertical direction, and
a second upper surface other than the first upper surface,
wherein the first upper surface and the second upper surface have a step difference.

9. The circuit board of claim 8, wherein the first circuit pattern layer includes a first circuit pattern disposed on the upper surface of the first-first insulating layer,
wherein the first circuit pattern includes:
a first-first pattern disposed on the first upper surface of the first-first insulating layer and overlapping the cavity in the vertical direction, and
a first-second pattern disposed on the second upper surface of the first-first insulating layer.

10. The circuit board of claim 9, wherein an upper surface of the first-first pattern is positioned lower than an upper surface of the first-second pattern.
